# EUROPÄISCHE PATENTSCHRIFT

(11) **EP 0 888 228 B1**
(45) Veröffentlichungstag und Bekanntmachung des Hinweises auf die Patenterteilung: **18.09.2002**
(21) Anmeldenummer: 97916389.6
(22) Anmeldetag: 26.03.1997
(51) Int. Cl.: B60T 8/36, F16K 27/00, H05K 3/30, H01F 27/02

(54) **REGLEREINHEIT**
CONTROL UNIT
UNITE DE REGULATION

(30) Priorität: 30.03.1996 DE 19612907
(43) Veröffentlichungstag der Anmeldung: 07.01.1999
(73) Patentinhaber: Continental Teves AG & Co. oHG, 60488 Frankfurt (DE)
(72) Erfinder: HEISE, Andreas, D-64546 Mörfelden (DE)
(74) Vertreter: Blum, Klaus-Dieter, Dipl.-Ing.
(86) Internationale Anmeldenummer: EP9701532
(87) Internationale Veröffentlichungsnummer: WO97036773

(56) Entgegenhaltungen:
- EP-A- 0 373 551
- EP-A- 0 492 110
- EP-A- 0 658 463
- WO-A-89/10286
- WO-A-92/12878
- US-A- 5 386 337
- ept Einpreßtechnik, Tcom Press ept-Gugelhör Peiting August 1990 Seiten 1 - 24 XP002033395 in der Anmeldung erwähnt

## Beschreibung

Die Erfindung bezieht sich auf eine Reglereinheit mit Spulen für elektromagnetisch betätigbare Ventile einer hydraulischen Bremsanlage mit einer Leiterplatte, auf der Halbleiterbauelemente angeordnet sind, wobei die Spulen über Anschlußdrähte mit den Bauelementen auf der Leiterplatte verbunden sind, wobei die Anschlußdrähte durch eine Trennwand im Gehäuse der Reglereinheit geführt sind und aus dieser herausragen, wobei die herausragenden Enden mit der Leiterplatte verbunden werden.

Eine derartige gattungsbildende Reglereinheit ist in der US-A-5386337 beschrieben. Die Anschlußdrähte verlaufen in einer Gußmasse, mit denen auch die Spulen im Gehäuse des Reglers gehalten sind. Lediglich die Enden der Anschlußdrähte ragen aus der Trennwand im Reglergehäuse hervor und werden mit der Leiterplatte verlötet. Dazu ist ein gesonderter Produktionsschritt notwendig, der sorgfältig durchgeführt werden muß, da bei diesem Lötvorgang die bereits verlöteten Bauelemente auf der bestückten Leiterplatte nicht beschädigt werden dürfen. Dies bedingt entweder ein aufwendiges Lötverfahren oder, daß die Bauelemente einen Abstand einhalten zu den Stellen, an denen die Enden der Anschlußdrähte mit der Leiterplatte verlötet werden. Daher weist die Leiterplatte eine entsprechend große flächige Ausdehnung auf.

Die Anschlußdrähte von je zwei paarweise zueinander zugeordneten Spulen werden derart abgebogen, daß die Enden der Drähte in einer Reihe liegen. Die Stromführungen in der Leiterplatte sowie die Anordnung der Bauelemente müssen dieser Anordnung angepaßt werden.

Aus der EP 37355 A2 ist eine Reglereinheit bekannt, bei der die Anschlußdrähte der Spulen zu einer Steckerleiste geführt werden, wobei die entsprechenden Anschlüsse der Leiterplatte in einem Gegenstecker angeordnet sind. Die Leiterplatte ist in einem Deckel angeordnet, wobei beim Aufsetzen des Deckels die Steckverbindung hergestellt wird. Diese Anordnung ist relativ aufwendig, da sowohl die Anschlüsse der Leiterplatte als auch die Anschlußdrähte der Spulen jeweils zu einer Steckerleiste geführt werden müssen.

Aus der genannten EP ist eine weitere Anordnung bekannt, bei der eine Zwischendecke im Reglergehäuse vorgesehen ist, die Leiterbahnen aufweist, wobei auf der Unterseite der Trennwandwand Stecker angeordnet sind, die mit aus den Spulengehäusen herausragenden Steckstiften zusammenwirken. Die Leiterbahnen in der Trennwand sind an einer Stelle freigelegt, so daß eine Verbindung zur Leiterplatte, die im Deckel des Gehäuses befestigt ist, hergestellt werden kann.

Aus der EP 658463 A2 ist eine Ventilsteuervorrichtung bekannt, bei der die Magnetspulen in einen Schacht der Reglereinheit eingeführt werden, und mittels einer Schnappverriegelung in ihr gehalten werden, die wie folgt realisiert ist:
An jeder Magnetspule sind mehrere Arme befestigt, die die Spule spinnenartig umgreifen. An ihren Enden sind Rastnasen vorgesehen. In den Schächten sind entsprechende Vertiefungen eingelassen, in denen die Rastnasen einschnappen können. Diese Anordnung bewirkt eine leicht pendelnde Aufnahme der Magnetspulen, so daß sich diese beim Aufsetzen auf einem Ventildom, in dem der Magnetanker geführt ist, ausrichten können.

In dem Prospekt der ept-Gugelhör Peiting GmbH & Co. Elektronische Präzisions-Technik mit dem Titel "ept Einpreßtechnik, Tcom Press", August 1990 wird die Einpreßtechnik für Einpreßpfosten in Leiterplatten beschrieben. Hierbei handelt es sich um besonders massive oder speziell geformte Einpreßpfosten, die festigkeitsmäßig an die relativ hohen erforderlichen Einpreß- und Auspreßkräfte angepaßt sind.

Die Erfindung beruht auf der Aufgabe, die Reglereinheit der gattungsbildenden Art so auszubilden, daß die Verbindung zwischen den Spulen und der Leiterplatte möglichst frei von mechanischen als auch thermischen Spannungen rasch und unter der Voraussetzung eines einfachen Toleranzausgleichs und Beibehaltung bisheriger Spulenanschlußdrähte erfolgen kann. Außerdem soll erreicht werden, daß die Leiterplatte eine möglichst geringe flächige Ausdehnung aufweist

Die Aufgabe wird für eine Reglereinheit der angegebenen Art mit den kennzeichnenden Merkmalen des Patentanspruchs 1 gelöst.

Wenn zusätzlich nicht nur die Enden der Anschlußdrähte der Spulen als Einpreßpfosten ausgebildet werden, sondern auch die Verbindung zu einem Stecker bzw. zu einem Elektromotor, braucht die Leiterplatte lediglich auf die in einer Ebene angeordneten Einpreßpfosten aufgedrückt zu werden, um einen sicheren elektrischen Kontakt zwischen den Anschlußdrähten und der Leiterplatte hervorzurufen.

Weitere Ausgestaltungen des Erfindungsgedankens sind in den Unteransprüchen beschrieben. Besonders wichtig ist es, daß die beim Einpressen auftretenden Kräfte nicht in die Spulen eingeleitet werden und daß mechanische Spannungen, die zum Beispiel bei thermischen Ausdehnungen der Materialien auftreten, nicht oder nur zum Teil auf die Einpreßkontakte wirken. Dazu wird vorgeschlagen, daß die Anschlußdrähte oberhalb der Trennwand im Reglergehäuse abgeknickt sind, so daß die Enden der Anschlußdrähte gegenüber der zugehörigen Spule versetzt sind. Vorzugsweise werden die Enden der Anschlußdrähte in einem Kunststoffhalter gehalten, der auf einem Sockel an der Trennwand aufliegt. Dieser Sockel nimmt die auftretenden Kräfte beim Einpreßvorgang auf. Gleichzeitig sorgt er dafür, daß die Enden der Anschlußdrähte exakt in eine Position gelangen, in denen sie mit den entsprechenden Einpreßlöchern in der Leiterplatte fluchten.

Alternativ zum Kunststoffhalter können die Enden der Anschlußdrähte mit Verriegelungs- bzw Fixierungselementen versehen werden, die vorzugsweise einstückig mit den Drähten ausgebildet sind und in entsprechend vorgeformte Aufnahmen auf der Trennwand einrasten.

Die Anschlußdrähte werden oberhalb der Trennwand frei ggf in Führungen verlegt. Dies hat den Vorteil, daß Toleranzen ausgeglichen werden können. Die Position der Enden der Anschlußdrähte wird durch die Position des Sockels bestimmt, so daß Toleranzen bei den Längen der Anschlußdrähte durch leichte Durchbiegungen derselben ausgeglichen werden.

Weiterhin werden die Anschlußdrähte bzw. ihre Länge und Orientierung zur Spule für alle Spulen gleich ausgerichtet, was natürlich bei der Anordnung der Stecker auf der Leiterplatte berücksichtigt werden muß.

Im folgenden wird die Erfindung anhand einiger Skizzen näher erläutert.

Dabei zeigen: die
- Fig. 1: die prinzipielle Anordnung von Spulen in einem Rahmen mit einer dazugehörigen Leiterplatte, wobei gleichzeitig eine mögliche Montageweise dargestellt wird, die
- Fig. 2: eine Spule mit den dazugehörigen Anschlußdräht mit einer schematisch dargestellten Trennwand, die
- Fig. 3: das Ende eines Anschlußdrahtes mit Verriegelungsarmen und der dazugehörigen Aufnahme, die
- Fig. 4: einen Anschlußplan, und die
- Fig. 5: eine alternative Montagemöglichkeit.

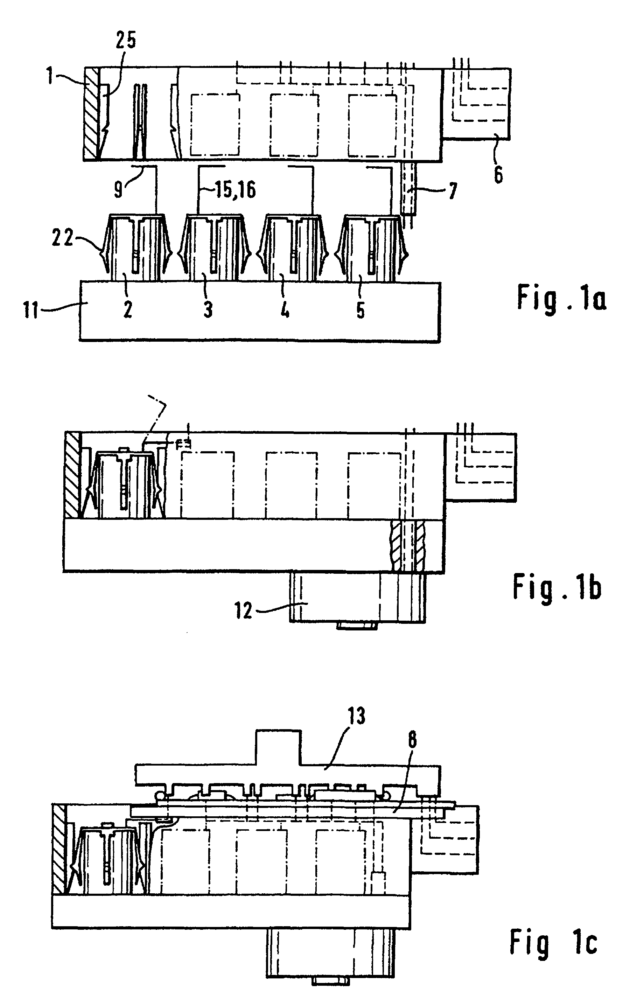

Zunächst wird auf die Fig. 1 Bezug genommen.

Diese zeigt eine Reglereinheit mit einem Rahmen 1, in dem mehrere Spulen 2,3,4,5 angeordnet sind. Die Zahl der Spulen richtet sich nach der Zahl der Elektromagnetventile, die z.B. in einer Bremsanlage benötigt werden.

Am Rahmen 1 befindet sich ein Stecker 6, an dem diverse Sensoren bzw Stromversorgungseinrichtungen angeschlossen werden können. Außerdem ist eine Verbindung 7 zu einem Elektromotor 12 vorgesehen. Wie man erkennt, sind die Enden 9 der Zuleitungen zum Stecker 6, zum Anschluß 7 und zu den Spulen 2,3,4,5 in einer Ebene angeordnet, wobei die flächige Ausdehnung des Bereichs, in dem die Anschlußenden vorgesehen sind, kleiner ist, als die flächige Ausdehnung des Rahmens 1.

Die Leiterplatte 8, die die elektronischen Bauelemente des Reglers trägt, ist, was nicht näher dargestellt ist, mit durchkontaktierten Löchern versehen, in denen die Enden 9 der Zuleitung eingesteckt werden, die als Einpreßpfosten ausgebildet sind. Wenn die Leiterplatte 8 auf die Enden gepreßt werden, drücken sich die Pfosten in die durchkontaktierten Löcher, so daß eine Verbindung in der sogenannten Einpreßtechnik hergestellt wird. Die Technik an sich ist bekannt. Es existieren z.B. zahlreiche Vorschläge, wie die Einpreßpfosten bzw. die Durchkontaktierungen ausgebildet werden können (siehe oben).

Die Spulen 2,3,4,5 sind mit jeweils drei oder vier Armen 22 versehen, die den Spulenkörper spinnenartig umgreifen und an deren Außenseite Rastnasen vorgesehen sind. Die Arme erstrecken sich längs des Spulenkörpers, wobei die Rastnase sich in etwa auf halber Höhe befindet. Im Rahmen 1 sind Führungen 25 vorgesehen, die mit einer entsprechenden Vertiefung versehen sind.

Die Spulen 2,3,4,5 werden nun im allgemeinen von unten , dh von der Seite , die dem Ventilblock zugewandt ist, in den Rahmen 1 eingeschoben, wobei die Arme 22 in den Führungen 25 gleiten, bis die Rastnasen in die Vertiefungen einschnappen. Damit sind die Ventilspulen derart pendelnd aufgehängt, daß sie sich noch leicht ausrichten könnten zu den Ventildomen des Ventilblocks 11 ausrichten können.

Wie man der Fig. 1a entnehmen kann, sind die Anschlußdrähte 15,16, an deren Enden die Einpreßkontakte 9 ausgebildet sind, vor der Montage in axialer Richtung ausgerichtet, wobei sie bei der Montage der Magnetspulen durch entsprechende Löcher in der Trennwand 10 geführt werden.

Sobald die Ventilspulen im Rahmen aufgehängt sind, werden die Anschlußdrähte 15,16, wie das der Fig. 1 b zu entnehmen ist, seitlich abgeknickt, so daß die Enden auf Sockeln zu liegen kommen, was weiter unten näher erläutert wird.

Anschließend kann, was in Fig. 1 c dargestellt ist, die Leiterplatte 8 auf die Einpreßkontakte 9 gedrückt werden, wodurch eine leitende Verbindung zwischen den elektronischen Bauelementen auf der Leiterplatte 8 und den Spulen, dem Motor und dem Kabelbaumstecker hergestellt wird.

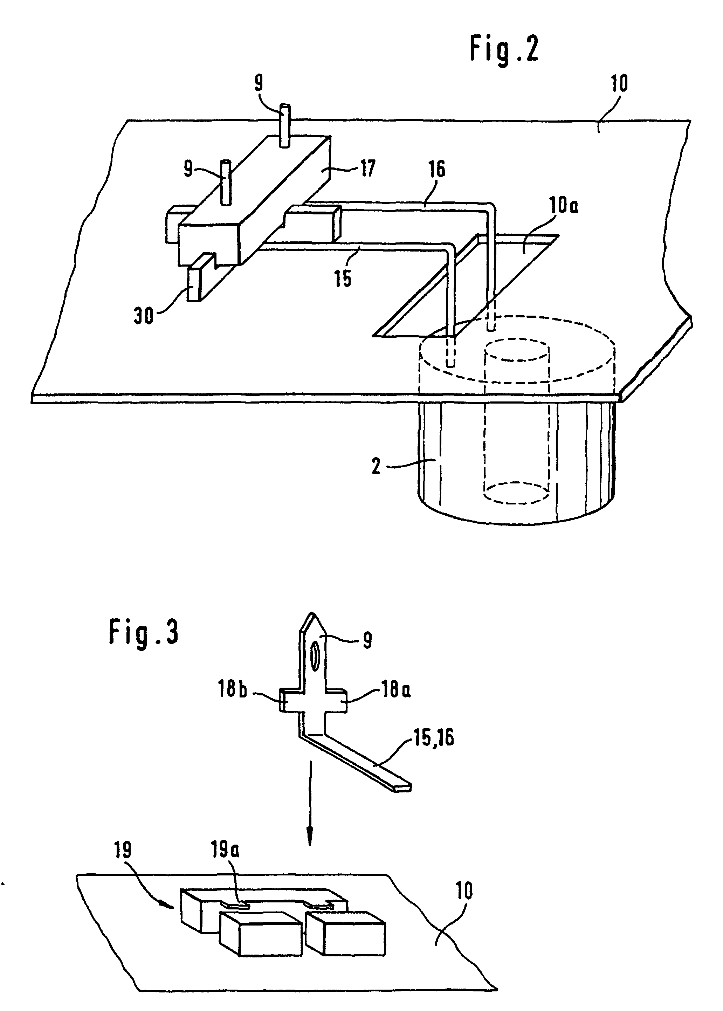

Die Fig. 2 zeigt eine Spule 2, die über zwei Anschlußdrähte 15,16 verfügt, die jeweils zweifach abgeknickt sind, wobei die Enden 9 als Einpreßpfosten ausgebildet sind. Der Einpreßpfosten kann z.B. so aussehen, daß das Ende 9 tonnenförmig verdickt und geriffelt ist, so daß eine reibschlüssige und gasdichte Verbindung mit dem entsprechenden Gegenkontakt in der Leiterplatte 8 entsteht. Eine andere Ausgestaltung des Einpreßpfostens sieht eine Gestaltung als Nadelöhr vor, wobei das Öhr breiter ist als der Draht. Die beiden Anschlußenden einer Spule werden durch einen Kunststoffhalter 17 miteinander verbunden.

Um insbesondere die Enden der Anschlußdrähte in die richtige Position bezogen auf die Leiterplatte zu bringen, wird folgende Vorgehensweise vorgeschlagen, die in Fig. 2 näher erläutert ist: In dieser Figur ist eine Trennwand 10 im Reglergehäuse schematisch dargestellt. Unterhalb der Trennwand 10 sind die Spulen 2 angeordnet, oberhalb werden die Anschlußdrähte geführt. Diese werden zusammen mit dem Kunststoffhalter durch ein Loch 10a in der Trennwand gesteckt und oberhalb des Loches seitlich abgeknickt, so daß Abschnitte der Anschlußdrähte 15,16 parallel zur Trennwand 10 verlaufen. Die Öffnungen 10a in der Trennwand 10 müssen entsprechend groß sein. Dieser Kunststoffhalter 17 liegt auf einem Sockel 30 auf, der einstückig mit der Trennwand 10 ausgebildet ist.

Der Sockel enthält Anschlagelemente, mit denen die Kunststoffhalter 17 in der Ebene der Trennwand 10 ausgerichtet und fixiert wird. Die Sockel bestimmen daher die Ausrichtung der Enden der Anschlußdrähte, so daß die jeweiligen Enden mit den entsprechenden Einpreßlöchern in der Leiterplatte 8 fluchten.

Diese Anordnung hat den Vorteil, daß die Kräfte beim Einpressen nicht in die Spule 2 sondern in die Trennwand eingeleitet werden. Die frei über der Trennwand 10 verlegten Anschlußdrähte 15,16 bewirken einen Toleranzausgleich, da diese leicht ausbiegen können, wenn die Länge der Drähte nicht mit dem Abstand der Spule 2 zum Sockel 30 übereinstimmt, bzw die Spulen höhenmäßige Toleranzen aufweisen.

Statt eines Kunststoffhalters 17, kann jedes Ende eines Anschlußdrahtes 15,16 unterhalb des Einpreßkontaktes 9 mit seitlich hervorstehenden Armen 18a, 18b versehen werden. Diese Arme werden einstückig mit den Anschlußdrähten 15,16 gebildet.

Auf der Trennwand 10 ist ein Sockel 19 mit Rasthaken 19a vorgesehen, der das abgeknickte Ende des Anschlußdrahtes 15,16 aufnimmt, wobei die Rasthaken 19a über die Arme 18a, 18b greifen und das Drahtende sicher fixieren.

Nimmt man gewisse Einschränkungen bei der flächigen Anordnung der Bauelement auf der Leiterplatte hin, können alle Spulen 2 und die dazugehörigen Anschlußdrähte 15,16 gleich, insbesondere hinsichtlich des Abstandes der Enden 9 zum Spulenkörper aufgebaut werden.

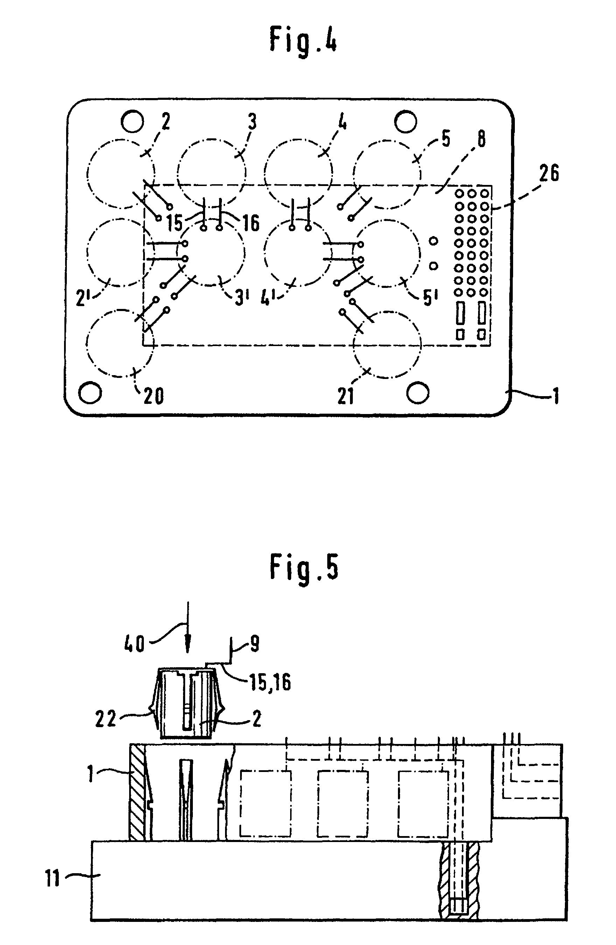

Die Fig. 4 zeigt eine typische Anordnung von Spulen 2,3,4,5;2',3',4',5',20,21 in einem Regler, wobei hier ein Regler mit zehn Spulen dargestellt ist. Die Lage der Spulen sind jeweils strichpunktiert angedeutet. Jede Spule verfügt über zwei kurze Anschlußdrähte 15,16, die alle in Einpreßpfosten enden. Die Anschlußdrähte der außenliegenden Spulen 2,3,4,5;2',5';20,21 sind jeweils nach innen gerichtet, wobei die Anschlußdrähte der beiden innenliegenden Spulen 3',4' nach außen gerichtet sind, so daß die Anschlußdrähte wieder in einem Bereich 26 liegen, der wesentlich kleiner ist als der von den Spulen umfaßte Bereich. Entsprechend gering kann die Ausdehnung der Leiterplatte 8 bemessen werden.

In Fig. 5 ist eine weitere Möglichkeit zur Montage der Spulen 2,3,4,5 dargestellt. Die Trennwand 10, was hier nicht näher dargestellt ist, weist Öffnungen auf, die so groß sind, wie der Durchmesser der einzusetzenden Spulen. Damit können die Spulen von oben (siehe Pfeil 40), d.h. von der Seite, an der später die Leiterplatte 8 eingesetzt wird, eingeführt werden. Dies wiederum hat den Vorteil, daß die Anschlußdrähte 15,16 schon vor der Montage abgeknickt werden können und die Enden der Anschlußdrähte schon bei der Montage der Ventilspulen lagerichtig auf ihre Sockel gesetzt werden können.

Bei dieser Anordnung entfällt somit der Montageschritt der Fig. 1b, bei dem die Anschlußdrähte erst nach der Montage der Ventilspulen abgeknickt werden. Weiterhin besteht die Möglichkeit, die Montage direkt auf dem Ventilblock 11 auszuführen und somit in die übliche Fertigungslinie zu integrieren.

## Patentansprüche

1. Reglereinheit mit Spulen (2, 3, 4, 5) für elektromagnetisch betätigbare Ventile einer hydraulischen Bremsanlage mit einer Leiterplatte (8), die elektronische Bauelemente aufnimmt, wobei die Spulen (2, 3, 4, 5) über Anschlußdrähte (15, 16) mit den elektronischen Bauelementen auf der Leiterplatte (8) verbunden sind, und diese Spulen (2, 3, 4, 5) unterhalb einer Trennwand (10) in einem Rahmen (1) des Reglergehäuses befestigt sind und die Enden (9) der Anschlußdrähte (15, 16) oberhalb der Trennwand (10) in Richtung der Leiterplatte (8) angeordnet sind, **gekennzeichnet durch** nachfolgende Merkmale:
- die Enden (9) der Anschlußdrähte (15, 16) sind als Einpreßpfosten ausgebildet,
- die Leiterplatte (8) weist kontaktierte Löcher auf, in die die Einpreßpfosten eingesteckt sind,
- die Anschlußdrähte (15, 16) weisen zwischen der Trennwand (10) und der Leiterplatte (8) frei verlegte Abschnitte auf, die auf der Trennwand (10) entlang verlaufen und die an ihren Enden (9) in Richtung der Leiterplatte (8) abgeknickt sind, die abgeknickten Enden (9) sind in die Löcher der Leiterplatte (8) eingepreßt,
- zur Aufnahme der Einpreßkraft stützen sich die Enden (9) auf einem Auflagesockel (30, 19) ab, der zwischen der Trennwand (10) und der Leiterplatte (8) angeordnet ist und der die Enden (9) fluchtend zu den Löchern der Leiterplatte (8) ausrichtet.

2. Reglereinheit nach Anspruch 1, **dadurch gekennzeichnet daß** die beiden Anschlußdrähte (15,16) einer Spule (2, 3, 4, 5) einen Kunststoffhalter (17) aufweisen, der unterhalb der Enden der Anschlußdrähte (15,16) diese miteinander verbindet.

3. Reglereinheit nach Anspruch 1 oder 2, **dadurch gekennzeichnet, daß** das Ende eines jeden Anschlußdrahtes (15, 16) mit Rastarmen (18a,18b) versehen ist.

4. Reglereinheit nach Anspruch 1, **dadurch gekennzeichnet, daß** auf der Oberseite der Trennwand (10) der Auflagesockel (30,19) für einen Kunststoffhalter (17), beziehungsweise für Rastarme (18a, 18b) vorgesehen sind.

5. Reglereinheit nach Anspruch 1, **dadurch gekennzeichnet, daß** der Auflagesockel (30, 19) die Enden (9) der Anschlußdrähte (15,16) zumindest in einer Richtung senkrecht zu dem Abschnitt der Anschlußdrähte (15,16), die parallel zur Trennwand (10) verlaufen, fixieren.

6. Reglereinheit nach Anspruch 1, **dadurch gekennzeichnet, daß** alle Spulen (2, 3, 4, 5) mit Anschlußdrähte (15,16) gleicher Länge versehen sind.

7. Reglereinheit nach Anspruch 1, **dadurch gekennzeichnet, daß** die Trennwand (10) so große Öffnungen (10a) aufweist, **daß** die Spulen (2, 3, 4, 5) von der Seite des Rahmens (1), in welche die Leiterplatte (8) eingesetzt wird, eingeführt werden können.

## Claims

1. Controller unit which includes coils (2, 3, 4, 5) for electromagnetically actuatable valves of a hydraulic brake system with a printed circuit board (8) on which electronic structural elements are mounted, wherein the coils (2, 3, 4, 5) are connected to the electronic structural elements on the printed circuit board (8) by way of lead wires (15, 16), and the said coils (2, 3, 4, 5) are attached below a partition wall (10) in a frame (1) of the controller housing and the ends (9) of the lead wires (15, 16) are arranged above the partition wall (10) in the direction of the printed circuit board (8),
**characterized by** the following features:
- the ends (9) of the lead wires (15, 16) are configured as press-in pins,
- the printed circuit board (8) includes holes with contacts into which the press-in pins are inserted,
- the lead wires (15, 16) include between the partition wall (10) and the printed circuit board (8) portions which are laid uncovered, which extend on the partition wall (10) and are bent at their ends (9) in the direction of the printed circuit board (8),
- the bent ends (9) are pressed into holes in the printed circuit board (8),
- to take up the press-in force, the ends (9) are supported on a support base (30, 19) which is arranged between the partition wall (10) and the printed circuit board (8) and makes the ends (9) align with the holes in printed circuit board (8).

2. Controller unit as claimed in claim 1,
**characterized in that** the two lead wires (15, 16) of a coil (2, 3, 4, 5) have a plastic holder (17) which interconnects the lead wires (15, 16) below their ends.

3. Controller unit as claimed in claim 1 or claim 2,
**characterized in that** the end of each lead wire (15, 16) includes locking arms (18a, 18b).

4. Controller unit as claimed in claim 1,
**characterized in that** support bases (30, 19) for a plastic holder (17) or locking arms (18a, 18b) are provided on the top side of the partition wall (10).

5. Controller unit as claimed in claim 1,
**characterized in that** the support bases (30, 19) fix the ends (9) of the lead wires (15, 16) at least in one direction vertically to the portion of the lead wires (15, 16) which extend in parallel to the partition wall (10).

6. Controller unit as claimed in claim 1,
**characterized in that** all coils (2, 3, 4, 5) have lead wires (15, 16) of equal length.

7. Controller unit as claimed in claim 1,
**characterized in that** the partition wall (10) includes openings (10a) of so large dimensions that the coils (2, 3, 4, 5) can be inserted from the side of the frame (1) into which the printed circuit board (8) is mounted.

## Revendications

1. Unité de régulation comportant des bobines (2, 3, 4, 5) pour des soupapes pouvant être actionnées électromagnétiquement d'une installation de freinage hydraulique avec une plaquette à circuits imprimés (8) qui reçoit des composants électroniques, les bobines (2, 3, 4, 5) étant reliées, par des fils de connexion (15, 16), aux composants électroniques sur la plaquette à circuits imprimés (8) et ces bobines (2, 3, 4, 5) étant fixées au-dessous d'une cloison (10) dans un cadre (1) du boîtier du régulateur, et les extrémités (9) des fils de connexion (15, 16) étant disposées au-dessus de la cloison (10), en direction de la plaquette à circuits imprimés (8),
**caractérisée par** les caractéristiques suivantes :
- les extrémités (9) des fils de connexion (15, 16) sont réalisées sous la forme de colonnettes à enfoncer,
- la plaquette à circuits imprimés (8) présente des trous métallisés dans lesquels sont enfichés les colonnettes à enfoncer,
- les fils de connexion (15, 16) présentent, entre la cloison (10) et la plaquette à circuits imprimés (8), des parties posées librement qui s'étendent le long de la cloison (10), sur celle-ci, et qui sont repliées à leurs extrémités (9) en direction de la plaquette à circuits imprimés (8),
- les extrémités repliées (9) sont enfoncées à l'intérieur des trous de la plaquette à circuits imprimés (8),
- pour absorber la force d'enfoncement, les extrémités (9) prennent appui sur un socle de support (30, 19) qui est disposé entre la cloison (10) et la plaquette à circuits imprimés (8) et qui oriente les extrémités (9) de manière qu'elles soient alignées avec les trous de la plaquette à circuits imprimés (8).

2. Unité de régulation selon la revendication 1, **caractérisée en ce que** les deux fils de connexion (15, 16) d'une bobine (2, 3, 4, 5) comportent un support (17) en matière plastique qui relie les fils de connexion (15, 16) entre eux au-dessous de leurs extrémités.

3. Unité de régulation selon la revendication 1 ou 2, **caractérisée en ce que** l'extrémité de chaque fil de connexion (15, 16) est pourvu de bras d'arrêt (18a, 18b).

4. Unité de régulation selon la revendication 1, **caractérisée en ce que** sur la face supérieure de la cloison (10) est prévu le socle de support (30, 19) pour un support (17) en matière plastique, ou pour des bras d'arrêt (18a, 18b).

5. Unité de régulation selon la revendication 1, **caractérisée en ce que** le socle de support (30, 19) fixe les extrémités (9) des fils de connexion (15, 16), au moins dans une direction perpendiculaire à la partie des fils de connexion (15, 16) qui s'étendent parallèlement à la cloison (10).

6. Unité de régulation selon la revendication 1, **caractérisée en ce que** toutes les bobines (2, 3, 4, 5) sont pourvues de fils de connexion (15, 16) de même longueur.

7. Unité de régulation selon la revendication 1, **caractérisée en ce que** la cloison (10) présente des ouvertures (10a) suffisamment grandes pour que les bobines (2, 3, 4, 5) puissent être introduites depuis le côté du cadre (1) dans lequel est insérée la plaquette à circuits imprimés (8).
